# EUROPÄISCHE PATENTSCHRIFT

(11) **EP 1 325 673 B1**
(45) Veröffentlichungstag und Bekanntmachung des Hinweises auf die Patenterteilung: **18.08.2004**
(21) Anmeldenummer: 01957666.9
(22) Anmeldetag: 02.08.2001
(51) Int. Cl.: H05K 1/03

(54) **LEITERPLATTE SOWIE VERFAHREN ZUM HERSTELLEN EINER SOLCHEN LEITERPLATTE UND EINES SCHICHTVERBUNDMATERIALS FÜR EINE SOLCHE LEITERPLATTE**
PRINTED CIRCUIT BOARD AND METHOD FOR PRODUCING A PRINTED CIRCUIT BOARD OF THIS TYPE AND FOR PRODUCING A LAMINAR COMPOSITE MATERIAL FOR SUCH A PRINTED CIRCUIT BOARD
CARTE DE CIRCUITS ET PROCEDE POUR PRODUIRE UNE TELLE CARTE DE CIRCUITS ET UN MATERIAU COMPOSITE EN COUCHE POUR PRODUIRE UNE TELLE CARTE DE CIRCUITS

(30) Priorität: 13.10.2000 CH 202000
(43) Veröffentlichungstag der Anmeldung: 09.07.2003
(73) Patentinhaber: PPC Electronic AG, 6330 Cham (CH)
(72) Erfinder: STRAUB, Peter, CH-6317 Oberwil bei Zug (CH); WEBER, Peter, CH-8803 Rüschlikon (CH)
(74) Vertreter: Ottow, Jens M., Dr.
(86) Internationale Anmeldenummer: PCT/CH2001/000472
(87) Internationale Veröffentlichungsnummer: WO 2002/032199

(56) Entgegenhaltungen:
- EP-A- 0 884 934
- EP-A- 0 972 632
- US-A- 2 913 632
- US-A- 4 017 642
- US-A- 4 715 117
- PATENT ABSTRACTS OF JAPAN vol. 1998, no. 02, 30. Januar 1998 (1998-01-30) & JP 09 270573 A (CMK CORP), 14. Oktober 1997 (1997-10-14)
- DATABASE WPI Week 198628 Derwent Publications Ltd., London, GB; AN 1986-178524 XP002169016 & JP 61 110546 A (SHOWA DENKO KK), 28. Mai 1986 (1986-05-28)
- PATENT ABSTRACTS OF JAPAN vol. 015, no. 351 (E-1108), 5. September 1991 (1991-09-05) & JP 03 136294 A (MATSUSHITA ELECTRIC IND CO LTD), 11. Juni 1991 (1991-06-11)
- PATENT ABSTRACTS OF JAPAN vol. 1997, no. 12, 25. Dezember 1997 (1997-12-25) & JP 09 208252 A (NITTO BOSEKI CO LTD;NITTO GURASUFUAIBAA KOGYO KK), 12. August 1997 (1997-08-12) in der Anmeldung erwähnt

## Beschreibung

### TECHNISCHES GEBIET

Die vorliegende Erfindung bezieht sich auf das Gebiet der elektronischen Schaltungstechnik. Sie betrifft eine Leiterplatte gemäss dem Oberbegriff des Anspruchs 1 sowie ein Verfahren zum Herstellen einer solchen Leiterplatte und eines Schichtverbundmaterials für eine solche Leiterplatte.

### STAND DER TECHNIK

In der heutigen elektronischen Schaltungstechnik, die sich insbesondere auf die Computertechnik sowie die Uebermittlung und Verarbeitung von Daten in der Kommunikationstechnik bezieht, geht die Entwicklung zu einer immer stärkeren Integration und Packungsdichte sowie zu immer höheren Taktfrequenzen, die im Normalfall bereits im GHz-Bereich liegen. Unter diesen Umständen kommt den Leiterplatten bzw. gedruckten Schaltungen beim Aufbau funktionssicherer und gleichzeitig kostengünstiger Schaltungen eine zunehmende Bedeutung zu. Zum einen muss eine solche Leiterplatte, insbesondere für grössere Serien, einfach und kostengünstig herzustellen und zu verarbeiten (schneiden, bohren, bestücken etc.) sein. Zum anderen muss die Leiterplatte eine ausreichende thermische und mechanische Stabilität sowie eine möglichst gute Wärmeleitfähigkeit aufweisen, weil wegen der hohen Integrationsdichte und hohen Frequenzen während des Betriebes in der Regel mit einem erheblichen Wärmeanfall zu rechnen ist. Weiterhin ist es wünschenswert, wenn die Leiterplatte bezüglich der thermischen Ausdehnung an die überall eingesetzten Halbleiterbauelemente (aus Si oder auch GaAs) angepasst ist, weil so eine direkte Montage der Halbleiterchips auf der Leiterplatte (Direct Chip Attach DCA) mit all ihren Vorteilen möglich wird.

Besonders wichtig sind im Hinblick auf die hohen Frequenzen jedoch die dielektrischen Eigenschaften des innerhalb der Leiterplatte eingesetzten Isolationsmaterials. So sollte eine im Höchstfrequenzbereich eingesetzte Leiterplatte eine Isolierschicht zwischen den Leiterschichten mit einer möglichst geringen (relativen) dielektrischen Konstante εᵣ und einem kleinen dielektrischen Verlustfaktor tanδ aufweisen, um die mit der Frequenz steigenden Verluste gering zu halten.

Schliesslich wird es bei den hohen Taktraten und sehr feinen Leiterbahnen immer wichtiger, dass sich das Leiterplattenmaterial durch eine grosse Homogenität im Dielektrikum und ein hohes Gleichmass in den äusseren Abmessungen (geringe Dickeschwankungen etc.) auszeichnet, weil sich sonst in benachbarten Bereichen der Leiterplatte unerwünschte Laufzeitunterschiede bei der Signalausbreitung ergeben, welche die Funktionalität der damit aufgebauten Schaltung beeinträchtigen.

Alle aufgeführten Forderungen werden von herkömmlichen Substratmaterialien auf Epoxydbasis nur schlecht oder gar nicht erfüllt. Es ist deshalb in der Vergangenheit bereits verschiedentlich vorgeschlagen worden, für einfache oder Multilayer-Leiterplatten isolierende Zwischenschichten aus einer gesinterten Glaskeramik einzusetzen, die gleichzeitig gute dielektrische Eigenschaften aufweisen und in ihrem thermischen Ausdehnungskoeffizienten beispielsweise an GaAs-Schaltungen angepasst sind (siehe z.B. die US-A-6,017,642). Derartige gesinterte Glaskeramiksubstrate sind jedoch aufwendig in der Herstellung und haben als Keramikplatten nur eine begrenzte mechanische Festigkeit, so dass mit ihnen insbesondere dünne, einlagige Leiterplatten nur schwer zu verwirklichen sind.

Ein anderer Vorschlag betrifft die Verwendung eines aus Glasfasern hergestellten "Glaspapiers" als Dielektrikum für gedruckte Schaltungsplatten (JP-A-9208252). Obgleich ein solches Fasermaterial gegenüber der Glaskeramik weniger bruchgefährdet sein dürfte, ergibt sich durch den unregelmässigen faserigen Aufbau des Materials eine lokale Inhomogenität in den dielektrischen Eigenschaften, die bei hohen Leitungsdichten und hohen Frequenzen zu den o.g. Laufzeitproblemen führen kann.

Die JP-A-09 270 573 zeigt eine Leiterplatte gemäß dem Oberbegriff von Anspruch 1, wobei die Isolierschicht eine Glasschicht ist.

Schliesslich ist eine ganze Klasse von Substratmaterialien für Leiterplatten bekannt, die aus mit Zusatzstoffen (Keramikpartikel, Glasfasern) gefüllten Fluorpolymeren bestehen (siehe z.B. die US-A-5,149,590). Derartige Materialien, die beispielsweise von der US-Firma Rogers Corp. unter den Bezeichnungen RT/duroid 5870-5880 und RO3000 im Handel angeboten werden, zeigen zwar relativ gute und homogene dielektrische Eigenschaften und sind daher für Höchstfrequenzanwendungen gut geeignet. Jedoch ist ein solches Material aufgrund der komplizierten Herstellung vergleichsweise teuer und hat zudem einen ungünstigen thermischen Ausdehnungskoeffizienten, der wesentlich höher ist als der von Silizium.

### DARSTELLUNG DER ERFINDUNG

Es ist daher Aufgabe der Erfindung, eine Leiterplatte zu schaffen, welche die Nachteile bekannter Leiterplatten vermeidet und sich bei vergleichsweise einfacher und kostengünstiger Herstellung durch sehr gute mechanische und thermische Eigenschaften auszeichnet, sehr gute dielektrische Eigenschaften aufweist und damit bis zu den höchsten Frequenzen einsetzbar ist, und in seiner thermischen Ausdehnung an die üblicherweise eingesetzten Si-Halbleiterchips optimal angepasst ist. Es ist weiterhin Aufgabe der Erfindung, ein Verfahren zur Herstellung einer solchen Leiterplatte anzugeben.

Die Aufgaben werden durch die Gesamtheit der Merkmale der Ansprüche 1, 15 und 21 gelöst. Der Kern der Erfindung besteht darin, als Dielektrikum in der Leiterplatte unterhalb der wenigstens einen, Leiterbahnen umfassenden Leiterschicht eine Dünnglasschicht vorzusehen, wie sie vor allem aus der Technik der Flüssigkristallanzeigen (LCDs) bekannt ist. Eine solche Dünnglasschicht weist selbst bei einer geringen Dicke eine gute mechanische Stabilität auf, hat sehr vorteilhafte dielektrische und thermische Eigenschaften und zeichnet sich durch eine hohe optische Qualität aus, die sich insbesondere in einer hohen Homogenität des Materials und einer hohen Planität mit geringen Ebenheits- und Dickenabweichungen manifestiert. Durch den Einsatz einer Dünnglasschicht als Dielektrikum gelingt es, alle Forderungen zu erfüllen, die an Leiterplatten für elektronische Schaltungen mit hoher Integrationsdichte und Höchstfrequenzen gestellt werden.

Eine bevorzugte Ausgestaltung der Erfindung ist dadurch gekennzeichnet, dass auf beiden Seiten der Dünnglasschicht jeweils eine Leiterschicht angeordnet und mit der Dünnglasschicht flächig verbunden ist. Eine Leiterschicht oder beide Leiterschichten können dabei strukturiert sein, d.h., einzelne Leiterbahnen umfassen. Eine derartige beidseitig mit einer Leiterschicht versehene Dünnglasschicht hat gegenüber der einseitig beschichteten den Vorteil, dass sich für eine damit realisierte elektronische Schaltung ein eindeutig definiertes Volumen ergibt, welches überwiegend mit dem Dünnglas-Dielektrikum gefüllt ist und entsprechend günstige Eigenschaften aufweist.

Bevorzugt ist die Dünnglasschicht aus der Schmelze gezogen und besteht aus einem modifizierten Borosilikatglas, wobei die Dünnglasschicht eine Dicke im Bereich von wenigen µm bis zu einigen mm, vorzugsweise im Bereich zwischen 30 µm und 1,1 mm, aufweist, bei 1MHz eine relative Dielektrizitätskonstante εᵣ zwischen 6 und 7, vorzugsweise von etwa 6,2, und einen dielektrischen Verlustfaktor tanδ von etwa 9x10⁻⁴ hat, und für Temperaturen zwischen 20 und 300 °C einen thermischen Ausdehnungskoeffizienten α₂₀₋₃₀₀ zwischen 4x10⁻⁶K⁻¹ und 8x10⁻⁶K⁻¹, vorzugsweise von etwa 4,5x10⁻⁶K⁻¹, aufweist.

Die Leiterschichten bestehen vorteilhafterweise jeweils aus einer Metallfolie, vorzugsweise einer Cu-Metallfolie, haben eine Dicke zwischen 5 und 50 µm, vorzugsweise von 18 oder 35 µm, und sind mit den Dünnglasschichten jeweils mittels einer Verbindungsschicht verklebt, wobei die Verbindungsschichten im wesentlichen aus einem Harz bestehen. Derartige harzbeschichtete Cu-Folien (Resin Coated Foil oder RCF) sind aus der Technik der HDl-Schaltungen, d.h., der Leiterplatten mit hohen Integrationsdichten, bekannt.

Bevorzugt ist bei den Verbindungsschichten als Haftvermittler zusätzlich ein Silan vorgesehen. Darüber hinaus ist es von Vorteil, wenn die Oberflächen der Dünnglasschichten zur Verbesserung der Haftung vorbehandelt sind.

Im einfachsten Fall besteht die Leiterplatte aus einer einzelnen, beidseitig mit Metallfolien verklebten Dünnglasschicht. Bei geringer Dicke der Dünnglasschicht ergibt sich so eine dünne, flexible Leiterplatte mit sehr guten elektrischen und thermischen Eigenschaften.

Es ist aber auch denkbar, dass die Leiterplatte in einem Stapel übereinander mehrere mit Metallfolien verklebte Dünnglasschichten umfasst und so eine Multilayer-Leiterplatte bildet, bei der in üblicher Weise auch Durchkontaktierungen vorgesehen werden können.

Ebenso ist es denkbar, dass die Leiterplatte neben einer Dünnglasschicht wenigstens eine weitere Isolierplatte aus einem anderen Isolierstoff umfasst. Die Kombination aus Leiterschicht(en) und Dünnglasschicht kann so mit Vorteil in eine Leiterplatte herkömmlicher Art integriert werden.

Weitere Ausführungsformen ergeben sich aus den abhängigen Ansprüchen.

### KURZE ERLÄUTERUNG DER FIGUREN

Die Erfindung soll nachfolgend anhand von Ausführungsbeispielen im Zusammenhang mit der Zeichnung näher erläutert werden. Es zeigen
- Fig. 1: in einer Schnittdarstellung den Aufbau einer unstrukturierten Leiterplatte gemäss einem ersten bevorzugten Ausführungsbeispiel der Erfindung;
- Fig. 2: die Leiterplatte aus Fig. 1 nach der (beidseitigen) Strukturierung der Leiterschichten und mit einem beispielhaft mittels der DCA-Methode direkt aufgebrachten Halbleiterchip;
- Fig. 3: in einer Schnittdarstellung den Aufbau einer (strukturierten) Leiterplatte gemäss einem zweiten bevorzugten Ausführungsbeispiel der Erfindung;
- Fig. 4: in einer Schnittdarstellung den Aufbau einer (strukturierten) mehrlagigen Leiterplatte gemäss einem dritten bevorzugten Ausführungsbeispiel der Erfindung;
- Fig. 5: in zwei Teilschritten (a) und (b) ein Verfahren zum Herstellen eines Schichtverbundmaterials für eine Leiterplatte nach Fig. 1 gemäss einem bevorzugten Ausführungsbeispiel der Erfindung; und
- Fig. 6: in sechs Teilschritten (a) bis (f) ein Verfahren zum Herstellen einer Leiterplatte nach Fig. 3 gemäss einem anderen bevorzugten Ausführungsbeispiel der Erfindung.

### WEGE ZUR AUSFÜHRUNG DER ERFINDUNG

Nachfolgend soll die Erfindung an Beispielen erläutert werden, bei denen eine Dünnglasschicht jeweils auf beiden Seiten mit einer strukturierten oder unstrukturierten Leiterschicht versehen ist. Grundsätzlich ist es im Rahmen der Erfindung jedoch auch denkbar, eine Leiterschicht nur auf einer Seite der Dünnglasschicht vorzusehen. Der Aufbau und das Verfahren zur Herstellung einer Leiterplatte bzw. eines Schichtverbundmaterials mit einer solchen einseitig "belegten" Dünnglasschicht ergeben sich aus den nachfolgenden Erläuterungen in analoger Weise.

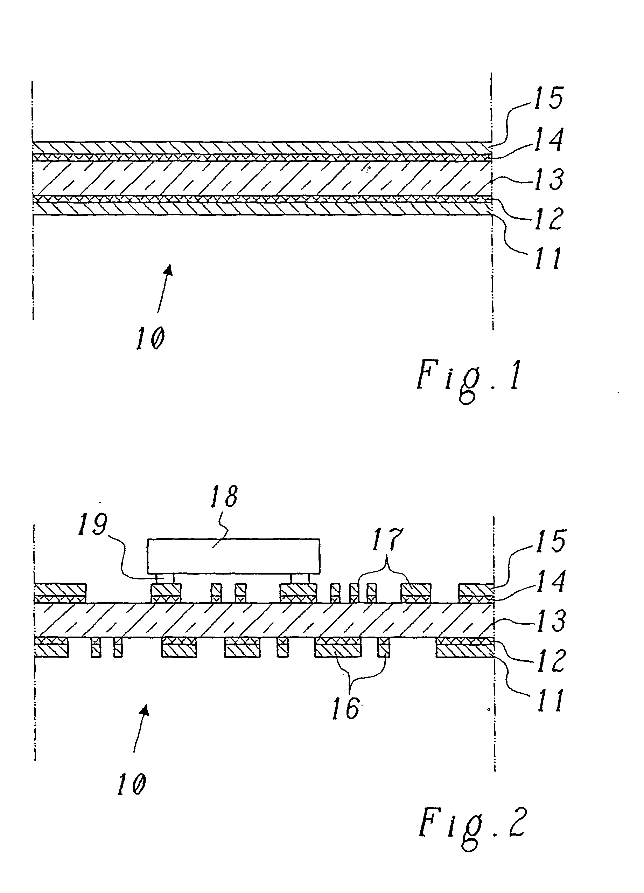

In Fig. 1 ist in einer Schnittdarstellung der Aufbau einer unstrukturierten Leiterplatte gemäss einem ersten bevorzugten Ausführungsbeispiel der Erfindung wiedergegeben. Die Leiterplatte 10 besteht in diesem Fall aus einer einzelnen Dünnglasschicht 13, auf deren beiden Seiten jeweils eine Leiterschicht 11 bzw. 15 angeordnet ist. Die Leiterschichten 11, 15 werden durch Cu-Metallfolien gebildet, die mittels einer klebenden Verbindungsschicht 12 bzw. 14 mit der Dünnglasschicht 13 flächig verklebt sind.

Dünnglasschichten, wie sie im Rahmen der Erfindung vorgesehen sind und zur Erreichung der erfindungsgemässen Vorteile eingesetzt werden, sind aus dem Stand der Technik bekannt (siehe z.B. die EP-A1-0 972 632 oder die DE-A1-198 10 325). Sie haben Dicken zwischen etwa 30 µm und 2 mm, sind aus der Schmelze gezogen, und zeichnen sich durch eine gute mechanische und optische Qualität sowie ausgezeichnete thermische und elektrische Eigenschaften aus. Derartige Dünnglasschichten werden kommerziell in grösserem Umfang für elektrooptische Anzeigen (z.B. LCDs) hergestellt und sind daher im Preis vergleichsweise günstig.

Geeignete Dünnglasschichten oder Dünngläser werden beispielsweise von der Firma Schott Glas, Mainz (DE) unter den Typenbezeichnungen AF 45 und D 263 T hergestellt und angeboten.

Das Dünnglas AF 45 ist ein modifiziertes Borosilikatglas mit einem hohen Anteil an BaO und Al₂O₃. Es ist normalerweise in Grössen bis zu 440 mm x 360 mm und zeichnet sich durch folgende Eigenschaften aus:

| AF 45 | |
|---|---|
| Dicke (Standard) | 50 µm bis 1900 µm |
| Transformationstemperatur T_{g} | 662 °C |
| therm. Ausdehnungskoeffizient α₂₀₋₃₀₀ | 4,5x10⁻⁶K⁻¹ |
| rel. Dielektrizitätskonstante εᵣ (bei 1 MHz) | 6,2 |
| dielektrischen Verlustfaktor tanδ | 9x10⁻⁴ |

Das Dünnglas D 263 T ist ein aus sehr reinen Ausgangsmaterialien hergestellten Borosilikatglas. Es ist ebenfalls in Grössen bis zu 440 mm x 360 mm erhältlich und zeichnet sich durch folgende Eigenschaften aus:

| D 263 T | |
|---|---|
| Dicke (Standard) | 30 µm bis 1100 µm |
| Transformationstemperatur T_{g} | 557 °C |
| therm. Ausdehnungskoeffizient α₂₀₋₃₀₀ | 7,2x10⁻⁶K⁻¹ |
| rel. Dielektrizitätskonstante εᵣ (bei 1 MHz) | 6,7 |
| dielektrischen Verlustfaktor tanδ | 61x10⁻⁴ |

Beide Dünnglasschichten bzw. Dünngläser eignen sich besonders gut zur Verwendung bei einer Leiterplatte nach der Erfindung.

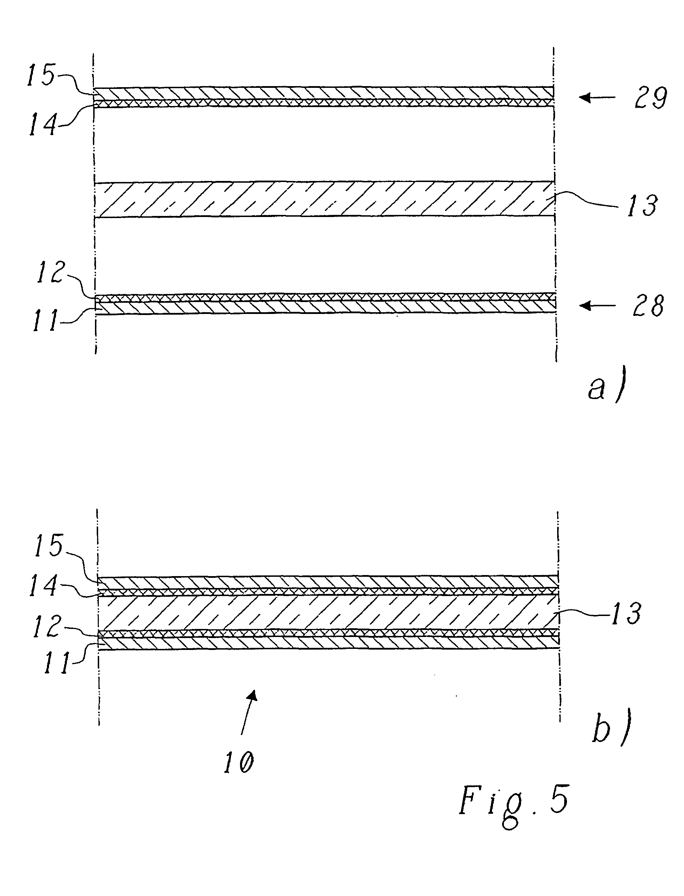

Die Herstellung eines geeigneten Schichtverbundmaterials für die (unstrukturierte) Leiterplatte 10 gemäss Fig. 1 erfolgt vorzugsweise in der in Fig. 5 dargestellten Weise: Es wird ausgegangen von einer Dünnglasschicht 13, deren Oberflächen zunächst von anhaftender Feuchtigkeit (Wasser) befreit und anschliessend - z.B. durch eine Glimmentladung oder dgl. - vorbehandelt werden, um beim nachfolgenden Verkleben eine gute und dauerhafte Haftung zu erzielen. Zur Erzeugung der Leiterschichten 11, 15 auf der Dünnglasschicht werden harzbeschichtete Metallfolien (Resin Coated Foils RCFs) 28, 29 aus Cu eingesetzt, auf deren Verklebungsseite jeweils eine Verbindungsschicht 12 bzw. 14 aufgebracht ist (Fig. 5a). Die Verbindungsschichten 12, 14 enthalten ein Harz, welches zweckmässigerweise teilweise ausgehärtet bzw. vorreagiert ist. Derartige harzbeschichtete Cu-Metallfolien sind aus der Technik der hochintegrierten (HDI-)Schaltungen bekannt.

Im Rahmen der Erfindung besonders geeignete harzbeschichtete Folien werden beispielsweise von der Firma Isola AG (DE) unter der Bezeichnung ISOFOIL 160 und RCC angeboten. Die (ISOFOIL 160)-Folien haben beispielsweise eine Dicke der Kupferfolien von 18 µm oder 35 µm und sind mit einer 75 µm dicken Harzschicht versehen, die vorreagiert ist (sog. B-Stage-Coating).

Die harzbeschichteten Folien 28, 29 werden unter zusätzlicher Verwendung einer Silanschicht zur Haftvermittlung (siehe dazu z.B. die US-A-5,149,590) mit der vorbehandelten zentralen Dünnglasschicht 13 zu einem Stapel gepackt. Der Stapel wird dann unter Einwirkung von Wärme und Druck verklebt (Fig. 5b). Als Ergebnis erhält man ein Schichtverbundmaterial bzw. eine (unstrukturierte) Leiterplatte 10 gemäss Fig. 1. Die Leiterschichten 11, 15 können dann unter Anwendung bekannter Methoden aus der Leiterplattenherstellung wahlweise strukturiert werden, um nach Bedarf bestimmte Leiterbahnen (oder Leiterflächen) 16, 17 zu erzeugen (Fig. 2). Auf die strukturierte Leiterplatte 10 gemäss Fig. 2 können dann beispielsweise SMD-Bauteile oder dgl. aufgelötet oder leitend aufgeklebt werden. Eine besonders vorteilhafte Art der Montage wird durch die an die üblichen Halbleitermaterialien angepassten thermischen Ausdehnungskoeffizienten der Dünnglasschicht 13 ermöglicht: So kann gemäss Fig. 2 ein mit entsprechenden Anschlusskontakten 19 versehener Halbleiterchip 18 direkt auf der Leiterplatte 10 montiert werden (sog. Direct Chip Attach DCA). Hierdurch lassen sich bei gleichzeitig vereinfachter Montage und hoher Zuverlässigkeit noch höhere Packungsdichten erreichen.

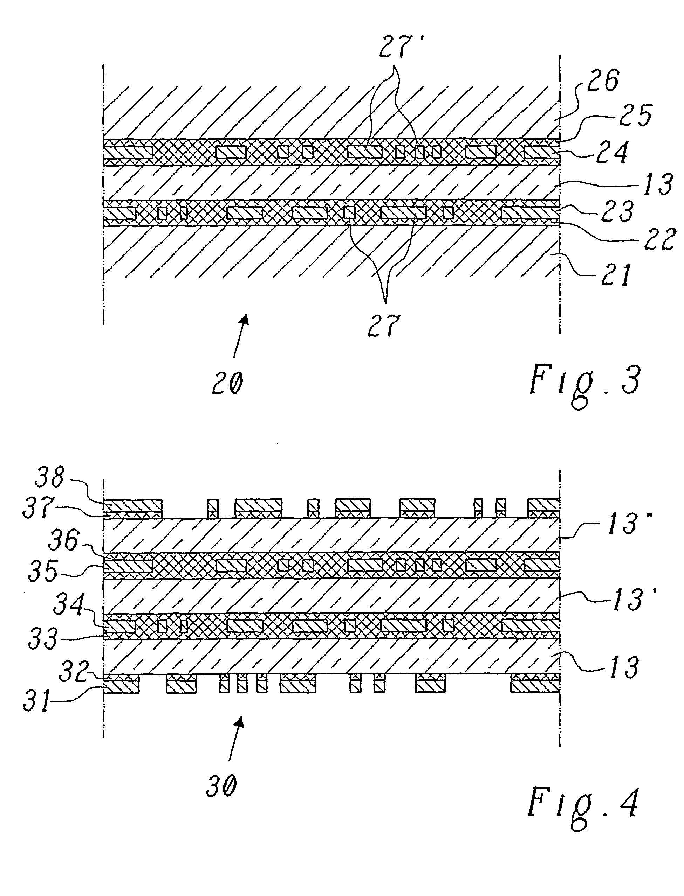

Neben der einfachen Leiterplatte 10 aus Fig. 1, 2 und 5, die nur eine Dünnglasschicht 13 und zwei Leiterschichten 11 und 15 umfasst und daher besonders dünn und flexibel ausgebildet werden kann, lassen sich in analoger Weise auch Multilayer-Leiterplatten 30 realisieren, die in einem Stapel übereinander mehrere Dünnglasschichten 13, 13' und 13" mit dazwischenliegenden Leiterschichten 34 und 35 und äusseren Leiterschichten 31, 38 umfassen (Fig. 4). Auch in diesem Fall ist zu jeder Leiterschicht eine entsprechende Verbindungsschicht 32, 33, 36, 37 vorgesehen, welche die Leiterschicht mit der jeweiligen Dünnglasschicht verklebt. Die inneren Leiterschichten 34, 35 sind dabei zweckmässigerweise in eine zugehörige Verbindungsschicht 33 bzw. 36 eingebettet. Selbstverständlich können bei einer derartigen Multilayer-Leiterplatte 30 auch (in Fig. 4 nicht gezeigte) Durchkontaktierungen vorhanden sein, die in an sich bekannter Weise hergestellt sind und Leiterbahnen in unterschiedlichen Leiterschichten miteinander verbinden.

Eine andere Möglichkeit im Rahmen der Erfindung besteht darin, eine einseitig oder beidseitig mit einer Leiterschicht versehene Dünnglasschicht in eine Leiterplatte herkömmlicher Art zu integrieren. So zeigt das in Fig. 3 dargestellte Beispiel eine Leiterplatte 20, bei der eine zentrale Dünnglasschicht 13 mit beidseitig aufgeklebten Leiterschichten 23, 24 und Leiterbahnen 27, 27' zwischen zwei lsolierplatten 21, 26 herkömmlicher Art (z.B. auf Epoxydharz- oder Polytetrafluoräthylenbasis) angeordnet und mit diesen Isolierplatten verklebt ist. Zur Verklebung dienen hier wiederum Verbindungsschichten 22, 25, in welche die Leiterschichten 23, 24 eingebettet sind.

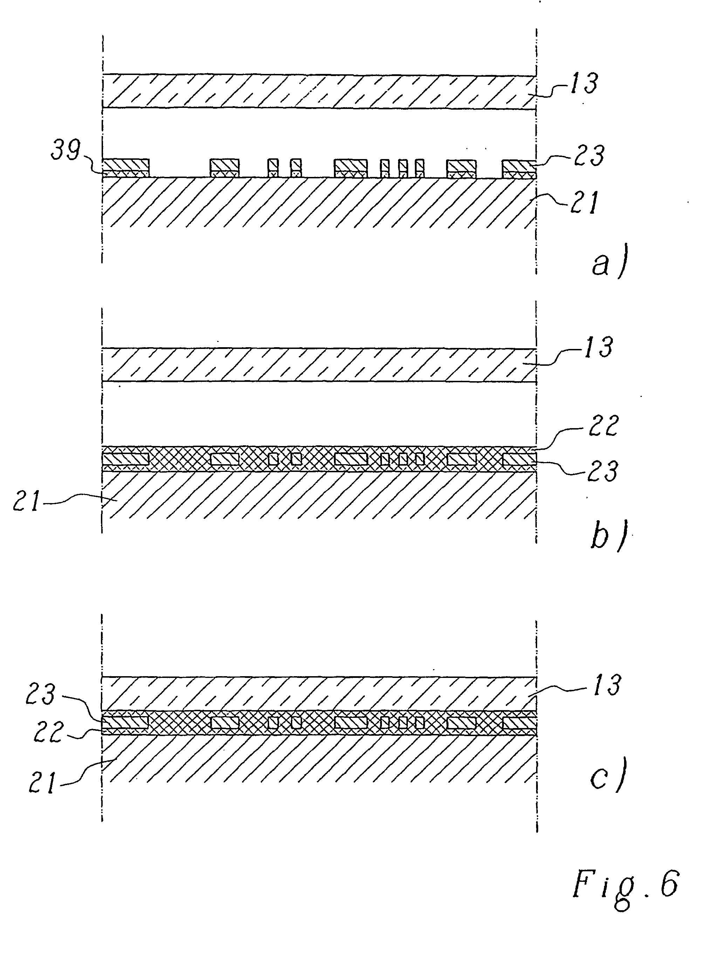

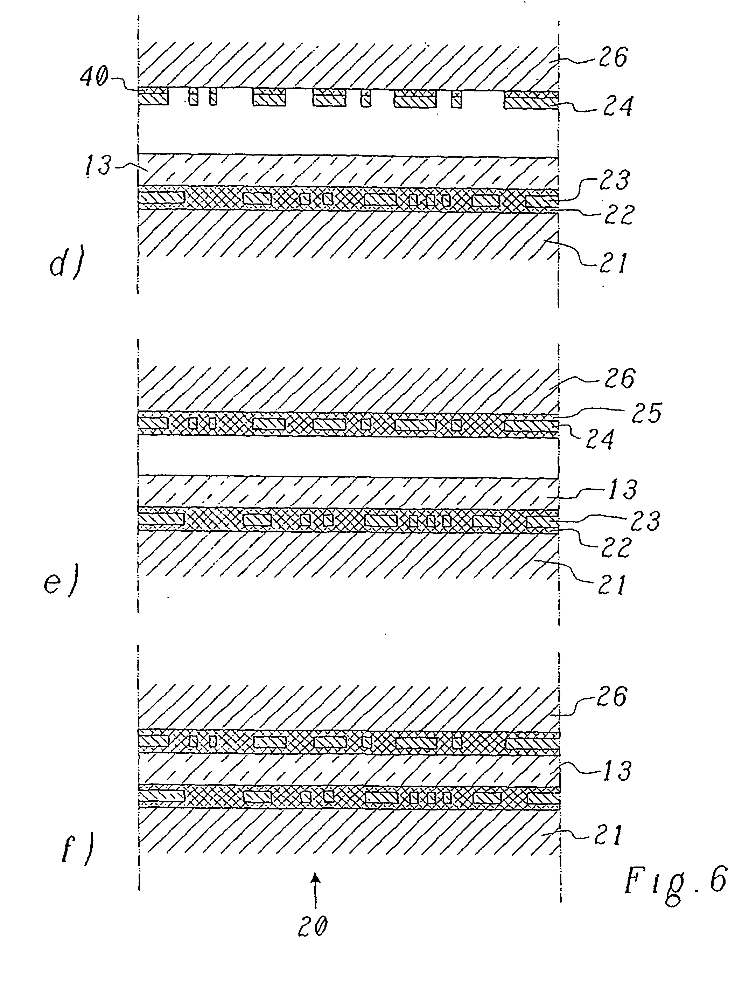

Die Herstellung einer solchen "hybriden"Leiterplatte 20 mit herkömmlichen Isolierplatten und Dünnglasschichten ist in verschiedenen Schritten in Fig. 6(a)-(f) dargestellt: Ausgangspunkt ist eine der Isolierplatten, nämlich die Isolierplatte 21, auf die in herkömmlicher Weise eine erste Leiterschicht 23 mittels einer ersten Verbindungsschicht 39 aufgeklebt und anschliessend strukturiert wird (Fig. 6a). Die erste Verbindungsschicht 39 wird dann unter Bedeckung der ersten Leiterschicht zur endgültigen Verbindungsschicht 22 aufgefüllt (Fig. 6b). Die so vorbereitete Struktur 21, 22, 23 wird daraufhin einseitig mit einer entsprechend vorbehandelten Dünnglasschicht 13 verklebt (Fig. 6c). Auf die freie Seite der Dünnglasschicht 13 kann dann eine weitere Struktur 24, 25, 26 geklebt werden (Fig. 6e,f), welche die mit einer zweiten Leiterschicht 24 versehene andere Isolierplatte 26 umfasst. Die zweite Leiterschicht 24 wird dabei mittels einer zweiten Verbindungsschicht 40 auf die Isolierplatte 26 geklebt, anschliessend strukturiert (Fig. 6d), und die zweite Verbindungsschicht 40 dann zur endgültigen Verbindungsschicht 25 aufgefüllt (Fig. 6e). Auch bei diesem Ausführungsbeispiel ist es denkbar, harzbeschichtete Cu-Metallfolien zur Herstellung der Leiterschichten 23 und 24 einzusetzen.

Insgesamt ergibt sich mit der Erfindung eine Leiterplatte, die sich durch folgende Eigenschaften und Vorteile auszeichnet:
- die Leiterplatten können ohne Einbusse an mechanischer Stabilität sehr dünn ausgeführt werden
- durch die Anpassung der thermischen Ausdehnungkoeffizienten des zentralen Dielektrikums (Dünnglas) an die gebräuchlichen Halbleitermaterialien ist eine direkte Montage von Halbleiterchips möglich
- die optische Qualität, Homogenität und Gleichmässigkeit in den Abmessungen des Dünnglasmaterials vermeiden störende Einflüsse auf die Signalausbreitung, insbesondere bei hohen Frequenzen
- die vergleichsweise gute thermische Leitfähigkeit der Dünnglasschicht erleichtert die Wärmeabfuhr und erlaubt so höhere Integrationsdichten
- die kleine Dielektrizitätskonstante und der kleine dielektrische Verlustfaktor des Dünnglasmaterials ermöglichen sehr hohe Frequenzen der auf der Leiterplatte angeordneten Schaltung
- die Dünnglasschichten sind in hervorragender Qualität und zu günstigen Preisen aus der Serienproduktion kommerziell erhältlich und begrenzen daher die Kosten der Leiterplatten
- die Dünnglasschichten lassen sich im Rahmen der Leiterplattenherstellung gut bearbeiten und verarbeiten; insbesondere können bekannte Methoden der Leiterplattenherstellung problemlos eingesetzt werden
- es können problemlos Multilayer-Leiterplatten hergestellt werden, die sich aufgrund der geringen Dicke der Dünnglasschichten noch kompakter ausbilden lassen
- aufgrund der grossen Homogenität und Gleichmässigkeit des Dielektrikums sind noch feinere Leiterbahnstrukturen möglich.

Das nach dem erfindungsgemässen Verfahren hergestellte Schichtverbundmaterial eignet sich besonders gut als Ausgangsmaterial für die Leiterplatte. Es ist aber auch denkbar, dieses Material in anderen Anwendungsfällen einzusetzen.

### BEZUGSZEICHENLISTE

- 10,20,30: Leiterplatte
- 11,15: Leiterschicht (Cu-Metallfolie)
- 12,14: Verbindungsschicht
- 13,13',13": Dünnglasschicht
- 16,17: Leiterbahn
- 18: Halbleiterchip
- 19: Anschlusskontakt (Halbleiterchip)
- 21,26: Isolierplatte (z.B. Epoxy)
- 22,25: Verbindungsschicht
- 23,24: Leiterschicht (Cu-Metallfolie)
- 27,27': Leiterbahn
- 28,29: harzbeschichtete Metallfolie (Cu)
- 31,34,35,38: Leiterschicht
- 32,33,36,37: Verbindungsschicht
- 39, 40: Verbindungsschicht

## Patentansprüche

1. Leiterplatte (10, 20, 30) für eine elektronische Schaltung, insbesondere für Höchstfrequenzen im GHz-Bereich, umfassend wenigstens eine Leiterschicht (11, 15; 23, 24; 31, 34, 35, 38), die auf einer Isolierschicht angeordnet ist, und die mit der Isolierschicht flächig verbunden ist, **dadurch gekennzeichnet, dass** die Isolierschicht eine Dünnglasschicht (13, 13', 13") ist, dass die Dünnglasschicht (13, 13', 13") aus der Schmelze gezogen ist und aus einem modifizierten Borosilikatglas besteht, und dass die Dünnglasschicht (13, 13', 13") eine Dicke im Bereich zwischen 30 µm und 1,1 mm aufweist.

2. Leiterplatte nach Anspruch 1, **dadurch gekennzeichnet, dass** auf beiden Seiten der Dünnglasschicht (13, 13', 13") jeweils eine Leiterschicht (11, 15; 23, 24; 31, 34, 35, 38) angeordnet und mit der Dünnglasschicht (13, 13', 13") flächig verbunden ist.

3. Leiterplatte nach einem der Ansprüche 1 oder 2, **dadurch gekennzeichnet, dass** die Dünnglasschicht (13, 13', 13") bei 1 MHz eine relative Dielektrizitätskonstante εᵣ zwischen 6 und 7, vorzugsweise von etwa 6,2, und einen dielektrischen Verlustfaktor tanδ von etwa 9x10⁻⁴ aufweist.

4. Leiterplatte nach einem der Ansprüche 1 bis 3, **dadurch gekennzeichnet, dass** die Dünnglasschicht (13, 13', 13") für Temperaturen zwischen 20 und 300 °C einen thermischen Ausdehnungskoeffizienten α₂₀₋₃₀₀ zwischen 4x10⁻⁶K⁻¹ und 8x10⁻⁶K⁻¹, vorzugsweise von etwa 4,5x10⁻⁶K⁻¹, aufweist.

5. Leiterplatte nach einem der Ansprüche 1 bis 4, **dadurch gekennzeichnet, dass** die Leiterschichten (11, 15; 23, 24; 31, 34, 35, 38) jeweils aus einer Metallfolie, vorzugsweise einer Cu-Metallfolie, bestehen.

6. Leiterplatte nach Anspruch 5, **dadurch gekennzeichnet, dass** die Metallfolien eine Dicke zwischen 5 und 50 µm, vorzugsweise von 18 oder 35 µm, aufweisen.

7. Leiterpfatte nach einem der Ansprüche 5 und 6, **dadurch gekennzeichnet, dass** die Metallfolien mit den Dünnglasschichten (13, 13', 13") jeweils mittels einer Verbindungsschicht (12, 14; 22, 25; 32, 33, 36, 37; 39, 40) verklebt sind.

8. Leiterplatte nach Anspruch 7, **dadurch gekennzeichnet, dass** die Verbindungsschichten (12, 14; 22, 25; 32, 33, 36, 37; 39, 40) im wesentlichen aus einem Harz bestehen.

9. Leiterplatte nach Anspruch 8, **dadurch gekennzeichnet, dass** bei den Verbindungsschichten (12, 14; 22, 25; 32, 33, 36, 37; 39, 40) als Haftvermittler zusätzlich ein Silan vorgesehen ist.

10. Leiterplatte nach einem der Ansprüche 7 bis 9, **dadurch gekennzeichnet, dass** die Verbindungsschichten (12, 14; 22, 25; 32, 33, 36, 37; 39, 40) jeweils eine Dicke von einigen 10 µm, vorzugsweise etwa 20 µm, zwischen den Leiterschichten (11, 15; 23, 24; 31, 34, 35, 38) und den benachbarten Dünnglasschichten (13, 13', 13") aufweisen.

11. Leiterplatte nach einem der Ansprüche 7 bis 10, **dadurch gekennzeichnet, dass** die Oberflächen der Dünnglasschichten (13, 13', 13") zur Verbesserung der Haftung vorbehandelt sind.

12. Leiterplatte nach einem der Ansprüche 1 bis 11, **dadurch gekennzeichnet, dass** die Leiterplatte (10) aus einer einzelnen, beidseitig mit Metallfolien verklebten Dünnglasschicht (13) besteht.

13. Leiterplatte nach einem der Ansprüche 1 bis 12, **dadurch gekennzeichnet, dass** die Leiterplatte (20) in einem Stapel übereinander mehrere mit Metallfolien verklebte Dünnglasschichten (13, 13', 13") umfasst.

14. Leiterplatte nach einem der Ansprüche 1 bis 11, **dadurch gekennzeichnet, dass** die Leiterplatte (20) neben einer Dünnglasschicht (13) wenigstens eine weitere Isolierplatte (21, 26) aus einem anderen Isolierstoff umfasst.

15. Verfahren zum Herstellen eines Schichtverbundmaterials, insbesondere für eine Leiterplatte nach einem der Ansprüche 1 bis 14, **dadurch gekennzeichnet, dass** eine aus der Schmelze gezogene und aus einem modifizierten Borosilikatglas bestehende Dünnglasschicht (13), die eine Dicke im Bereich zwischen 30 µm und 1,1 mm aufweist, dadurch mit einer Leiterschicht (11, 15; 23, 24; 31, 34, 35, 38) versehen wird, dass sie wenigstens auf einer Seite flächig mit einer harzbeschichteten Metallfolie (28, 29), insbesondere einer harzbeschichteten Cu-Metallfolie, verklebt wird.

16. Verfahren nach Anspruch 15, **dadurch gekennzeichnet, dass** die Dünnglasschicht (13) beidseitig mit einer harzbeschichteten Metallfolie (28, 29), insbesondere einer harzbeschichteten Cu-Metallfolie, verklebt wird.

17. Verfahren nach einem der Ansprüche 15 und 16, **dadurch gekennzeichnet, dass** der gebildete Schichtverbund mit weiteren Dünnglasschichten (13', 13") und harzbeschichteten Metallfolien verklebt wird.

18. Verfahren nach einem der Ansprüche 15 bis 17, **dadurch gekennzeichnet, dass** eine Dünnglasschicht (13) verwendet wird, welche
(a) bei 1MHz eine relative Dielektrizitätskonstante εᵣ zwischen 6 und 7, vorzugsweise von etwa 6,2, und einen dielektrischen Verlustfaktor tanδ von etwa 9x10⁻⁴ aufweist, und
(b) für Temperaturen zwischen 20 und 300 °C einen thermischen Ausdehnungskoeffizienten α₂₀₋₃₀₀ zwischen 4x10⁻⁶K⁻¹ und 8x10⁻⁶K⁻¹, vorzugsweise von etwa 4,5x10⁻⁶K⁻¹, aufweist.

19. Verfahren nach einem der Ansprüche 15 bis 18, **dadurch gekennzeichnet, dass** die harzbeschichteten Metallfolien eine Dicke der Metallfolie von zwischen 5 und 50 µm, vorzugsweise von 18 oder 35 µm, aufweisen.

20. Verfahren nach einem der Ansprüche 15 bis 19, **dadurch gekennzeichnet, dass** die Oberflächen der Dünnglasschicht (13) zur Verbesserung der Haftung vorbehandelt sind.

21. Verfahren zum Herstellen einer Leiterplatte nach einem der Ansprüche 1 bis 14, **dadurch gekennzeichnet, dass** zur Bildung eines in die Leiterplatte (20) integrierten Schichtverbundes eine aus der Schmelze gezogene und aus einem modifizierten Borosilikatglas bestehende Dünnglasschicht (13), die eine Dicke im Bereich zwischen 30 µm und 1,1 mm aufweist, zumindest einseitig flächig mit einer Isolierplatte (21, 26) verklebt wird, welche auf der Verklebungsseite mit einer Leiterschicht (23, 24) versehen ist.

## Claims

1. Printed circuit board (10, 20, 30) for an electronic circuit, in particular for extremely high frequencies in the GHz range, comprising at least one conductor layer (11, 15; 23, 24; 31, 34, 35, 38), which is arranged on an insulating layer and which is connected to the insulating layer in planar fashion, **characterized in that** the insulating layer is a thin glass layer (13, 13', 13'') **in that** the thin glass layer (13, 13', 13'') is pulled from the melt and comprises a modified borosilicate glass, and **in that** the thin glass layer (13, 13', 13'') has a thickness in the range between 30 µm and 1.1 mm.

2. Printed circuit board according to Claim 1, **characterized in that** a respective conductor layer (11, 15; 23, 24; 31, 34, 35, 38) is arranged on both sides of the thin glass layer (13, 13', 13'') and connected to the thin glass layer (13, 13', 13'') in planar fashion.

3. Printed circuit board according to either of Claims 1 and 2, **characterized in that** the thin glass layer (13, 13', 13") has, at 1 MHz, a relative permittivity εᵣ of between 6 and 7, preferably of about 6.2, and a dielectric loss factor tanδ of about 9 x 10⁻⁴.

4. Printed circuit board according to one of Claims 1 to 3, **characterized in that** the thin glass layer (13, 13', 13'') has, for temperatures of between 20 and 300°C, a thermal expansion coefficient α₂₀₋₃₀₀ of between 4 x 10⁻⁶K⁻¹ and 8 x 10⁻⁶K⁻¹, preferably of about 4.5 x 10⁻⁶ K⁻¹.

5. Printed circuit board according to one of Claims 1 to 4, **characterized in that** the conductor layers (11, 15; 23, 24; 31, 34, 35, 38) in each case comprise a metal foil, preferably a Cu metal foil.

6. Printed circuit board according to Claim 5, **characterized in that** the metal foils have a thickness of between 5 and 50 µm, preferably of 18 or 35 µm.

7. Printed circuit board according to either of Claims 5 and 6, **characterized in that** the metal foils are adhesively bonded to the thin glass layers (13, 13', 13'') in each case by means of a connecting layer (12, 14; 22, 25; 32, 33, 36, 37; 39, 40).

8. Printed circuit board according to Claim 7, **characterized in that** the connecting layers (12, 14; 22, 25; 32, 33, 36, 37; 39, 40) essentially comprise a resin.

9. Printed circuit board according to Claim 8, **characterized in that** the connecting layers (12, 14; 22, 25; 32, 33, 36, 37; 39, 40) are additionally provided with a silane as adhesion promoter.

10. Printed circuit board according to one of Claims 7 to 9, **characterized in that** the connecting layers (12, 14; 22, 25; 32, 33, 36, 37; 39, 40) each have a thickness of a few 10 µm, preferably about 20 µm, between the conductor layers (11, 15; 23, 24; 31, 34, 35, 38) and the adjacent thin glass layers (13, 13', 13'').

11. Printed circuit board according to one of Claims 7 to 10, **characterized in that** the surfaces of the thin glass layers (13, 13', 13'') are pretreated in order to improve the adhesion.

12. Printed circuit board according to one of Claims 1 to 11, **characterized in that** the printed circuit board (10) comprises an individual thin glass layer (13) which is adhesively bonded to metal foils on both sides.

13. Printed circuit board according to one of Claims 1 to 12, **characterized in that** the printed circuit board (20) comprises, in a stack one above the other, a plurality of thin glass layers (13, 13', 13'') adhesively bonded to metal foils.

14. Printed circuit board according to one of Claims 1 to 11, **characterized in that** the printed circuit board (20) comprises, besides a thin glass layer (13), at least one further insulating plate (21, 26) made of a different insulating material.

15. Method for producing a layer composite material, in particular for a printed circuit board according to one of Claims 1 to 14, **characterized in that** a thin glass layer (13), which is pulled from the melt, comprises a modified borosilicate glass and has a thickness in the range between 30 µm and 1.1 mm, is provided with a conductor layer (11, 15; 23, 24; 31, 34, 35, 38) by being adhesively bonded at least on one side, in planar fashion, to a resin-coated metal foil (28, 29), in particular a resin-coated Cu metal foil.

16. Method according to Claim 15, **characterized in that** the thin glass layer (13) is adhesively bonded to a resin-coated metal foil (28, 29), in particular a resin-coated Cu metal foil, on both sides.

17. Method according to either of Claims 15 and 16, **characterized in that** the layer composite formed is adhesively bonded to further thin glass layers (13', 13'') and resin-coated metal foils.

18. The method according to one of Claims 15 to 17, **characterized in that** a thin glass layer (13) is used which
(a) has, at 1 MHz, a relative permittivity εᵣ of between 6 and 7, preferably of about 6.2, and a dielectric loss factor tanδ of about 9 x 10⁻⁴ and
(b) has, for temperatures of between 20 and 300°C, a thermal expansion coefficient α₂₀₋₃₀₀ of between 4 x 10⁻⁶K⁻¹ and 8 x 10⁻⁶K⁻¹, preferably of about 4.5 x 10⁻⁶K⁻¹.

19. Method according to one of Claims 15 to 18, **characterized in that** the resin-coated metal foils has a metal foil thickness of between 5 and 50 µm, preferably of 18 or 35 µm.

20. Method according to one of Claims 15 to 19, **characterized in that** the surfaces of the thin glass layer (13) are pretreated in order to improve the adhesion.

21. Method for producing a printed circuit board according to one of Claims 1 to 14, **characterized in that**, in order to form a layer composite integrated into the printed circuit board (20), a thin glass layer (13), which is pulled from the melt, comprises a modified borosilicate glass and has a thickness in the range between 30 µm and 1.1 mm, is adhesively bonded to an insulating plate (21, 26) at least on one side, in planar fashion, which insulating plate is provided with a conductor layer (23, 24) on the adhesive-bonding side.

## Revendications

1. Carte de circuit (10, 20, 30) pour un circuit électronique, en particulier pour des fréquences très élevées, dans la plage des GHz, qui comprend au moins une couche conductrice (11, 15; 23, 24; 31, 34, 35, 38) disposée sur une couche isolante et reliée à la couche isolante par toute sa surface, **caractérisée en ce que** la couche isolante est une mince couche de verre (13, 13', 13"), **en ce que** la mince couche de verre (13, 13', 13") est étirée à l'état fondu et est constituée d'un verre au borosilicate modifié et **en ce que** la mince couche de verre (13, 13', 13") présente une épaisseur comprise dans la plage 30 µm à 1,1 mm.

2. Carte de circuit selon la revendication 1, **caractérisée en ce qu'**une couche (11, 15; 23, 24; 31, 34, 35, 38) est disposée sur chacun des côtés de la mince couche de verre (13, 13', 13") et est reliée sur toute sa surface à la mince couche de verre (13, 13', 13").

3. Carte de circuit selon l'une des revendications 1 ou 2, **caractérisée en ce que** la mince couche de verre (13, 13', 13") présente à 1 MHz une constante diélectrique relative εᵣ comprise entre 6 et 7, de préférence d'environ 6,2, et un facteur de perte diélectrique tan δ d'environ 9 x 10⁻⁴.

4. Carte de circuit selon l'une des revendications 1 à 3, **caractérisée en ce que** la mince couche de verre (13, 13', 13") présente à des températures comprises entre 20 et 300° C un coefficient de dilatation thermique α₂₀₋₃₀₀ compris entre 4 x 10⁻⁶ K⁻¹ et 8 x 10⁻⁶ K⁻¹ et de préférence d'environ 4,5 x 10⁻⁶ K⁻¹.

5. Carte de circuit selon l'une des revendications 1 à 4, **caractérisée en ce que** les couches conductrices (11, 15; 23, 24; 31, 34, 35, 38) sont chacune constituées d'une feuille métallique, de préférence d'une feuille métallique en Cu.

6. Carte de circuit selon la revendication 5, **caractérisée en ce que** les feuilles métalliques présentent une épaisseur comprise entre 5 et 50 µm et de préférence entre 18 et 35 µm.

7. Carte conductrice selon l'une des revendications 5 et 6, **caractérisée en ce que** les feuilles métalliques sont toutes deux collées sur les minces couches de verre (13, 13', 13") au moyen d'une couche de liaison (12, 14; 22, 25; 32, 33, 36, 37; 39, 40).

8. Carte de circuit selon la revendication 7, **caractérisée en ce que** les couches de liaison (12, 14; 22, 25; 32, 33, 36, 37; 39, 40) sont essentiellement constituées d'une résine.

9. Carte de circuit selon la revendication 8, **caractérisée en ce qu'**un silane est de plus prévu dans les couches de liaison (12, 14; 22, 25; 32, 33, 36, 37; 39, 40) pour servir d'agent de renforcement de l'adhérence.

10. Carte de circuit selon l'une des revendications 7 à 9, **caractérisé en ce que** les couches de liaison (12, 14; 22, 25; 32, 33, 36, 37; 39, 40) entre les couches conductrices (11, 15; 23, 24; 31, 34, 35, 38) et les minces couches de verre (13, 13', 13") voisines présentent chacune une épaisseur de quelques dizaines de µm et de préférence d'environ 20 µm.

11. Carte de circuit selon l'une des revendications 7 à 10, **caractérisée en ce que** les surfaces des minces couches de verre (13, 13', 13") sont prétraitées pour améliorer l'adhérence.

12. Carte de circuit selon l'une des revendications 1 à 11, **caractérisée en ce que** la plaque de circuit (10) est constituée d'une seule mince couche de verre (13) avec une feuille métallique collée sur chacune de ses faces.

13. Carte de circuit selon l'une des revendications 1 à 12, **caractérisée en ce que** la carte de circuit (20) comprend plusieurs minces couches de verre (13, 13', 13"), sur lesquelles sont collées des feuilles métalliques, et empilées les unes sur les autres.

14. Carte de circuit selon l'une des revendications 1 à 11, **caractérisée en ce que** la carte de circuit (20) comprend en plus d'une mince couche de verre (13) au moins une autre plaque isolante (21, 26) en un autre matériau isolant.

15. Procédé de fabrication d'un matériau composite feuilleté, en particulier pour une carte de circuit selon l'une des revendications 1 à 14, **caractérisé en ce qu'**une mince couche de verre (13) étirée à l'état fondu et constituée d'un verre au borosilicate modifié, qui présente une épaisseur comprise dans la plage de 30 µm à 1,1 mm, est dotée d'une couche conductrice (11, 15; 23, 24; 31, 34, 35, 38) de telle sorte qu'une feuille métallique (28, 29), revêtue de résine, en particulier une feuille métallique en Cu revêtue de résine, est collée à plat sur un côté.

16. Procédé selon la revendication 15, **caractérisé en ce que** sur les deux côtés de la mince couche de verre (13) sont collées des feuilles métalliques (28, 29) revêtues de résine, en particulier des feuilles métalliques en Cu revêtues de résine.

17. Procédé selon l'une des revendications 15 et 16, **caractérisé en ce que** d'autres minces couches de verre (13', 13") et d'autres feuilles métalliques revêtues de résine sont collées sur le composite feuilleté ainsi formé.

18. Procédé selon l'une des revendications 15 à 17, **caractérisé en ce que** l'on utilise une mince couche de verre (13) qui présente:
(a) à 1 MHz une constante diélectrique relative εᵣ comprise entre 6 et 7, de préférence d'environ 6,2, et un facteur de perte diêlectrique tan δ d'environ 9 x 10⁻⁴ et
(b) à des températures comprises entre 20 et 300° C un coefficient de dilatation thermique α₂₀₋₃₀₀ compris entre 4 x 10⁻⁶ K⁻¹ et 8 x 10⁻⁶ K⁻¹ et de préférence d'environ 4,5 x 10⁻⁶ K⁻¹.

19. Procédé selon l'une des revendications 15 à 18, **caractérisé en ce que** la feuille métallique des feuilles métalliques revêtues de résine présente une épaisseur comprise 5 et 50 µm et de préférence entre 18 et 35 µm.

20. Procédé selon l'une des revendications 15 à 19, **caractérisé en ce que** les surfaces de la mince couche de verre (13) sont prétraitées pour améliorer l'adhérence.

21. Procédé de fabrication d'une carte de circuit selon l'une des revendications 1 à 14, **caractérisé en ce que** pour former un composite feuilleté intégré dans la carte de circuit (20), sur une mince couche de verre (13) étirée à l'état fondu et constituée d'un verre au borosilicate modifié, qui présente une épaisseur comprise dans la plage de 30 µm à 1,1 mm, on colle au moins d'un côté et sur toute sa surface une plaque isolante (21, 26) qui est dotée d'une couche conductrice (23, 24) sur le côté du collage.
